Europäisches Patentamt

European Patent Office

Office européen des brevets

(11) Publication number: **0 290 697**
**A2**

## EUROPEAN PATENT APPLICATION

(21) Application number: **87309386.8**

(22) Date of filing: **23.10.87**

(51) Int. Cl.⁴: **H01L 33/00**

(30) Priority: **12.05.87 US 48691**

(43) Date of publication of application:
**17.11.88 Bulletin 88/46**

(84) Designated Contracting States:
**DE ES GB IT NL**

(71) Applicant: **Chen, Shen-Yuan**
**37 Chung Shan Rd., Sec. 2**
**Chung Ho City Taipei Hsien(TW)**

(72) Inventor: **Chen, Shen-Yuan**
**37 Chung Shan Rd., Sec. 2**
**Chung Ho City Taipei Hsien(TW)**

(74) Representative: **Prentice, Raymond Roy**
**R.R. Prentice & Co. 34 Tavistock Street**
**London WC2E 7PB(GB)**

(54) Light emitting diodes (LED) lamp and its quick manufacturing method.

(57) This invention is the quick manufacturing meth-
od of a kind of Light Emitting Diodes (LED) lamp
especially the quick manufacturing method of a kind
of LED lamp for which the luminous crystal dice
(20) soldered on a leg (10) and the crystal dice (20)
and bonding (21) covered with resin film (22) will be
put in a mold (30) for plastic ejection to make form
so as to avoid the traditional process by long time
baking for about nine hours.

FIG.5

# LIGHT EMITTING DIODES (LED) LAMP AND ITS QUICK MANUFACTURING METHOD

The invention relates to a Light Emitting Diodes (LED) lamp and its quick manufacturing method.

The Light Emitting Diodes lamps are widely used for the indication of various instruments and their form-making used to adopt resin-filling method. The phases of the evolution of their mold making method are as follows: Initially, the male mold in lamp shape was made first. From the male mold, rubber female mold was made. Then, the lamp legs were inserted in female mold and filled with resin (Epoxy Resin is the typical). After resin was hardened after cooling, the lamps were taken out from the mold.

Because it takes very long time to make a mold of raw rubber and the rubber is apt to harden and become unserviceable after used for 10 times under temperature of 150 C. Therefore, upon the discovery of silicon temperature-proof rubber, it was widely used for molds making LED lamps.

Not long after, as the silicon temperature-proof rubber was still unsuitable for repeated use, a kind of copper mold was developed. A solid male mold was made first and a female mold was punched out at the copper column end by hot forging method. The copper columns were fixed on a suppot for using as mold to make LED lamp form. This method is most commonly used at present.

Presently, there is a newer temperature-proof compound plastic which can eject for form-making and be used to manufacture LED lamps. However, it is quite expensive in cost and such material can not be receivered for reuse. Thus, it has not been actually accepted by manufacturers of LED lamps. Obviously, the traditional production type has been devoted to the improvement of mold material for resin filling and equipment and it has been unable to develop a kind of brand new method for quick production of LED lamps.

In traditional resin filling method for form making, no matter what kind of material for form-making mold is used, it is unavoidable to confront with a most difficult process i. e. to fix lamp legs in the mold hold and fill up with resin for putting in oven after combination and fixation, to bake for eight hours. (Any attempt to raise oven temperature for shortening baking time will make resin brittle and broken in inserviceable condition.) After disassembly of mold, hardened form-making lamp is dug out and the mold holes should be cleaned. It is quite tedious and the oven plus conveying equip ment cost over several million dollars. Furthermore, it occupies a big piece of land plus highly astonished consumption of power.

In short, the manufacturing method of traditional Light Emitting Diodes (LED) lamps has maintained a long process:

To expand crystal dice for extending distances between individual crystals —➤ coat legs with silver solution —➤ to poke luminous crystal dice on legs —➤ baking (150°C for 40 minutes) —➤ soldering bonding —➤ putting in mold to fill up with resin and lock up mold —➤ short baking (220°C for 40 minutes) —➤ disassemble the mold, dig out coagulated and formed lamps and clean the mold —➤ long baking (85°C for 8 hours) —➤ cut single legs —➤ outward appearance inspection —➤ light intensity test —➤ cut legs entirely —➤ packing.

Through overall process, the bottleneck taking most time lies on the four phases after soldering the bonding i. e. from resin filling till long baking. It takes nine hours which is very uneconomic. The requirement of such long time process is due to the consideration of the characteristics of resin material which can not be hardened for coagulation rapidly. But owing to the apparent difference in process time from several seconds to several hours in the traditional manufacturing method, all efforts exerted for automatic production and balancing various process speed to improve production equipment of LED single point lamp has been unsuccessed and it still relies on considerable amount of manual works.

The major object of this invention is to furnish a kind of LED lamp suitable for mass production by ejection form-making and the light intensity of the lamp is upgraded.

The secondary object of this invention is to furnish a quick manufacturing method of LED lamp.

For reaching above-mentioned objects of this invention, the leg ends for lamp electric conduction will be coated with silver solution. After soldering and fixing luminous crystal dice and bonding, the legs will be placed invertedly to make crystal dice and bonding partially submerge in resin solution. It will be taken out and hung invertedly for baking so that the resin outside of crystal and bonding will be hardened to form a solid protection layer. Then it will be put in mold and the protection layer will be wrapped with diaphanic plastics through the ejection form-making method to construct the outward shape of the lamp.

The effectiveness of this invention will shorten the traditional process from resin filling to long baking (about 9 hours) into 30 seconds and the production speed will be apparently raised.

The process of this invention is:

Expanding crystal dice —➤ silver solution coated on ranked legs —➤ to poke luminous crystal dice on legs —➤ baking (150°C for 40 minutes) —➤ to solder bonding and stain resin at the crystal dice end ⟶ short baking of legs (150°C for 10 minutes) put in mold horizontally ⟶ ejection ⟶ disassemble mold ⟶ cut single legs ⟶ outward appearance inspection ⟶ light intensity test ⟶ cut legs ⟶ packing.

Fig. 1 is the isometric view of ranked legs and crystal dices before combination;

Fig. 2 is the plan view of ranked leg and crystal dice submerging in resin tank after combination;

Fig. 3 is the magnified front view of ranked leg end showing formation of water drop shaped film by resin outside of crystal dice and bonding;

Fig. 4 is the cross sectional view of 4-4 is Fig. 3;

Fig. 5 is the cross sectional view showing legs put in mold ready for plastic ejection;

Fig. 6 is the cross sectional view showing mold set apart status after legs put in mold and lamp form-made by ejection.

The following are codes of parts in figures:

10 - leg
20 - crystal dice
21 - bonding
22 - resin
30 - main mold
31 - hole
40 - upper mold
41 - lower mold
401 - material hole
402 - vent
50 - lamp
51 - ends
60 - resin tank

Description of manufacturing method of the invention set forth as following:

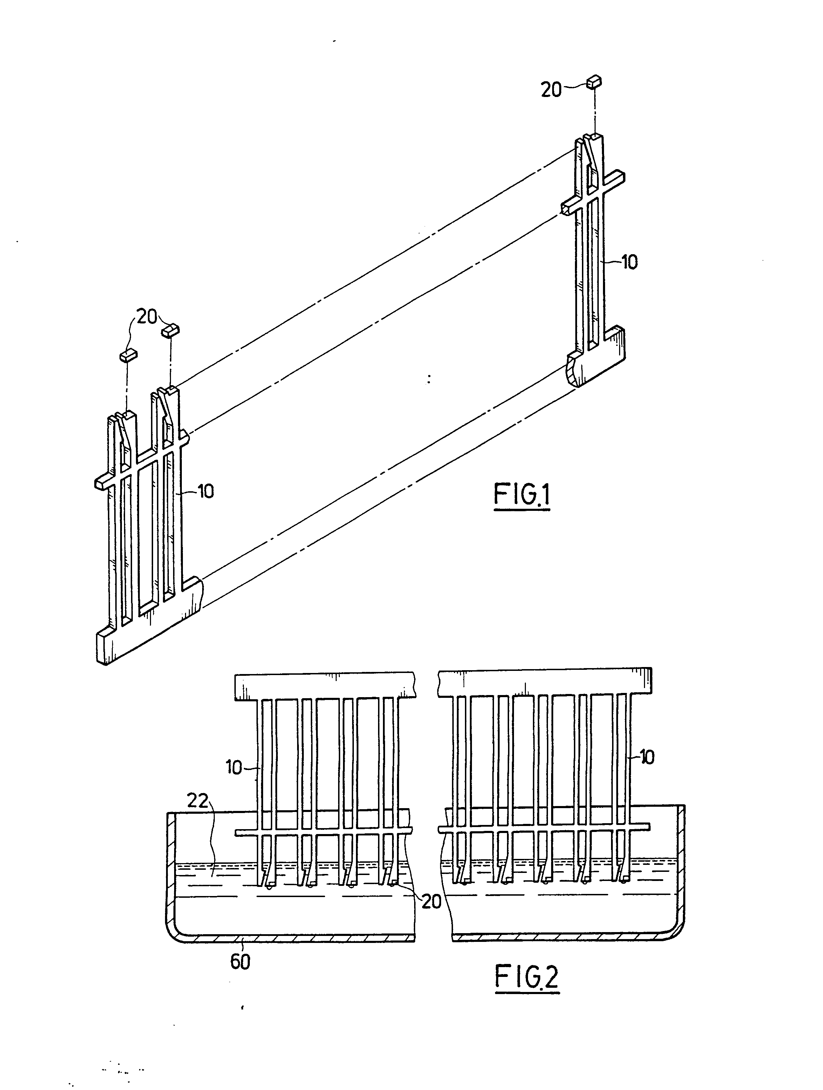

First expand the film of intensive luminous crystal dice to extend distances between individual crystal dice, as indicated in Fig. 1 and Fig. 2 electric conductivity silver solution is coated on the end of ranked leg 10. Then, the crystal dices 20 on the film are respectively poked on the end of leg 10, the crystal dices 20 are baked under 150°C approximately for about 40 minutes. After taking out, bonding 21 is soldered on crystal dice 20, the above process is similar to traditional method but the following is special in the invention:

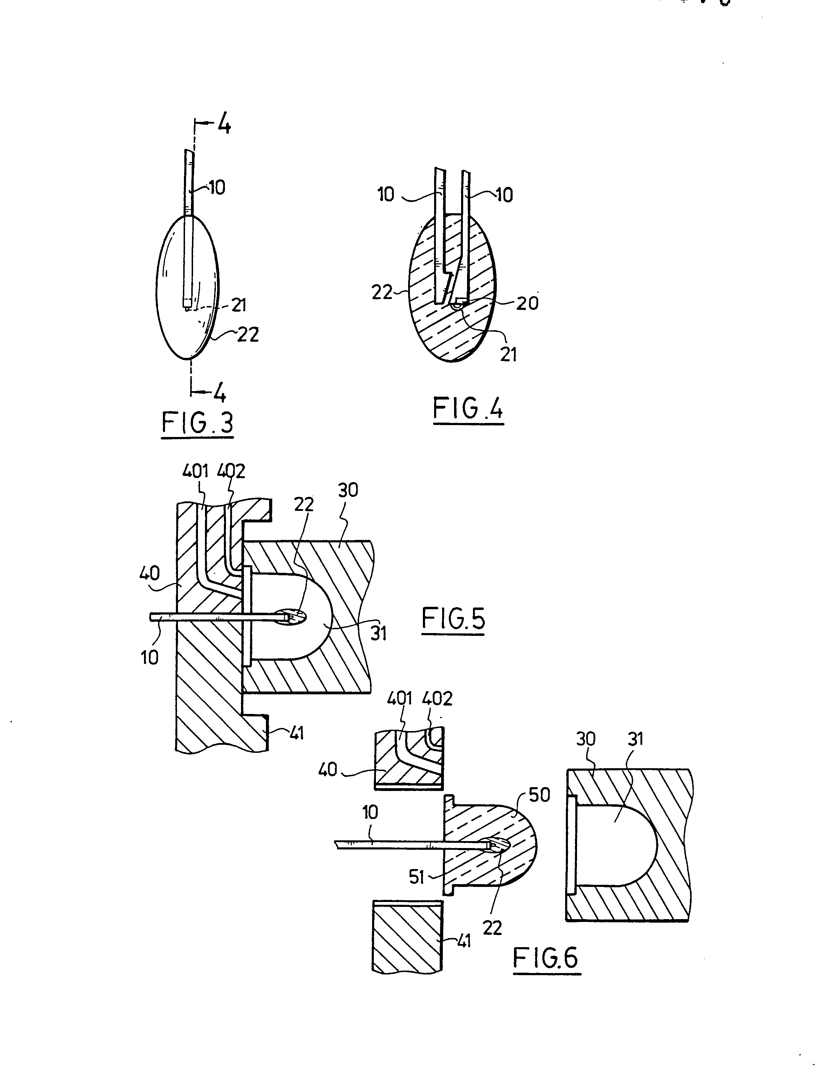

Place the ranked legs 10 invertedly and conveyed either by conveyor belt or by proper manual method. As indicated in Fig. 2, it will slightly submerge in resin tank 60 to make leg's crystal dices stain with resin 22. Because of centripetal force, resin will automatically cover on crystal dice 20 and bonding 21, as indicated in Fig. 3 and Fig. 4, forming a shape of water drop. To bake leg 10 under temperature about 150°C for 10 minutes and to make resin 22 coagulate and harden, then it will be put in mold 30. As indicated in Fig. 5, place the ranked legs horizontally and put crystal dice facing main mold 30, the main mold has hold 31 in same shape as that of the lamp. After ranked leg is sent to the central part of the hole 31, it will be sealed from the end 51 of lamp 50 along main mold 30 hole 31 in the two movable pieces of upper mold 40 and the lower mold 41 as indicated in Fig. 5. It will be ejected with highly diaphanic plastics such as acry through the feed hole 401 of upper mold 40 (or lower mold 41) to fill up hole 31 and the gas in hole 31 will be automatically exhausted from vent 402, because of the protection of resin's 22 thin film, the highly speedy folwing plastic material will not destroy crystal dice 20 and bonding 21 (the tensile strenghth of crystal dice and bonding is about 8 g/mm$^2$). Then main mold 30, upper mold 40 and lower mold are set apart in sequence as indicated in Fig. 6. The coagulated lamp 50 can be taken apart from mold area and sent to next process ready for cutting legs, inspection and packing.

As manufacturing method of LED single point lamp is concerned, the traditional method is too tediously long and it is not consistent with the demand of economic production cost. Moreover, the production speed is too slow i. e. each production line can only male about 200 ea per hour. As LED single point lamp is broadly used in various places with big market demand, the traditional manufacturing method cannot meet the requirement of producation effectiveness. Furthermore, the interior of lamps formed by resin has obvious resin folwing layer streaks causing the lamp blur and the light intensity is hard to be upgraded.

The manufacturing method of this invention is a really brand new one which is entirely apart from the set pattern of traditional method and the lamp is formed by ejection of acry, ABS ect. with diaphaneity close to that of glasses. The lamp has very high light intensity and its production can reach over 2000 ea per hour with high industrial and commercial value.

**Claims**

1. A kind of quick manufacturing method of LED lamps set forth as following:

To coat silver solution on ranked legs, poke luminous crystal dice on places coated with silver solution, sent in oven to bake under temperature about 150°C until silver solution died up, solder bonding with crystal dice, stain resin on crystal and bonding connection, re-bake to harden resin for coagulation, put the crystal dice end of ranked legs in mold for ejection, wrap diaphanic plastics around resin film outside of luminous crystal dice of legs and obtain lamp formation wanted.

2. According to claim 1 wherein, the diaphanic plastics is acry.

3. According to claim 1 wherein, crystal dice and bonding stained with resin will be placed invertedly and baked until resin dried and coagulated.

4. A kind of LED lamp of which the leg end is soldered with a luminous crystal dice and bonding and the outer layer of crystal dice and bonding has a resin protection layer in addition to the diaphanic plastics wrapping around crystal dice, bonding, leg ends and resin protection layer so as to construct the outward shape of the lamp.

20

20

10

10

FIG.1

10

10

22

20

60

FIG.2

FIG.3

FIG.4

FIG.5

FIG.6